# FASCICULE DE BREVET EUROPEEN

(11) **EP 2 936 572 B1**
(45) Date de publication et mention de la délivrance du brevet: **21.12.2016**
(21) Numéro de dépôt: 13774430.6
(22) Date de dépôt: 10.10.2013
(51) Int. Cl.: H01L 33/08, H01L 33/18, H01L 33/00, H01L 21/02, H01L 29/06, H01L 33/24

(54) **PROCÉDÉ OPTIMISÉ DE FABRICATION DE NANOFILS ÉLECTROLUMINESCENTS**
OPTIMIERTES VERFAHREN ZUR HERSTELLUNG ELEKTROLUMINESZENTER NANODRÄHTE
OPTIMISED METHOD FOR PRODUCING ELECTROLUMINESCENT NANOWIRES

(30) Priorité: 20.12.2012 FR 1262474
(43) Date de publication de la demande: 28.10.2015
(73) Titulaire: Aledia, 38040 Grenoble Cedex (FR)
(72) Inventeur: CAGLI, Carlo, F-38000 Grenoble (FR)
(74) Mandataire: Esselin, Sophie
(86) Numéro de dépôt international: PCT/EP2013/071161
(87) Numéro de publication internationale: WO 2014/095110

(56) Documents cités:
- DE-A1- 10 312 526
- US-A1- 2012 164 767

## Description

Le domaine de l'invention est celui des composants à base de nanofils électroluminescents pouvant être utilisés par exemple pour produire de la lumière, notamment des diodes électroluminescentes, couramment désignées par l'acronyme LED (« Light Emitting Diode »).

Au cours de ces dernières années, il a été réalisé par exemple, des diodes électroluminescentes (LEDs) visibles à base de nanofils InGaN/GaN verticaux contenant une jonction p-n et connectés collectivement en parallèle (voir par exemple US2012/0164767 A1).

De manière générale, on désigne par nanofils, des fils pouvant présenter des dimensions pour leur base pouvant atteindre jusqu'à plusieurs centaines de nanomètres.

Grâce à leurs propriétés intrinsèques potentielles (bonne qualité cristalline, relaxation des contraintes aux surfaces libres verticales, bonne efficacité d'extraction de la lumière par effet de guide d'onde...), les nanofils sont considérés comme des candidats très intéressants pour pallier les difficultés rencontrées actuellement avec des LEDs GaN conventionnelles fabriquées en structure planaire (2D).

Deux approches LEDs Nanofils, basées sur des techniques de croissance différentes, ont été développées au CEA Grenoble.

La première filière consiste à épitaxier des nanofils GaN contenant des puits quantiques InGaN en configuration axiale par Epitaxie par Jet Moléculaire (MBE). Les dispositifs fabriqués à partir de ces nanofils ont donné des résultats intéressants dans le domaine spectral vert. Les puces processées de 1 mm² peuvent émettre autour de 10 µW à 550 nm pour un courant continu de fonctionnement de 100 mA.

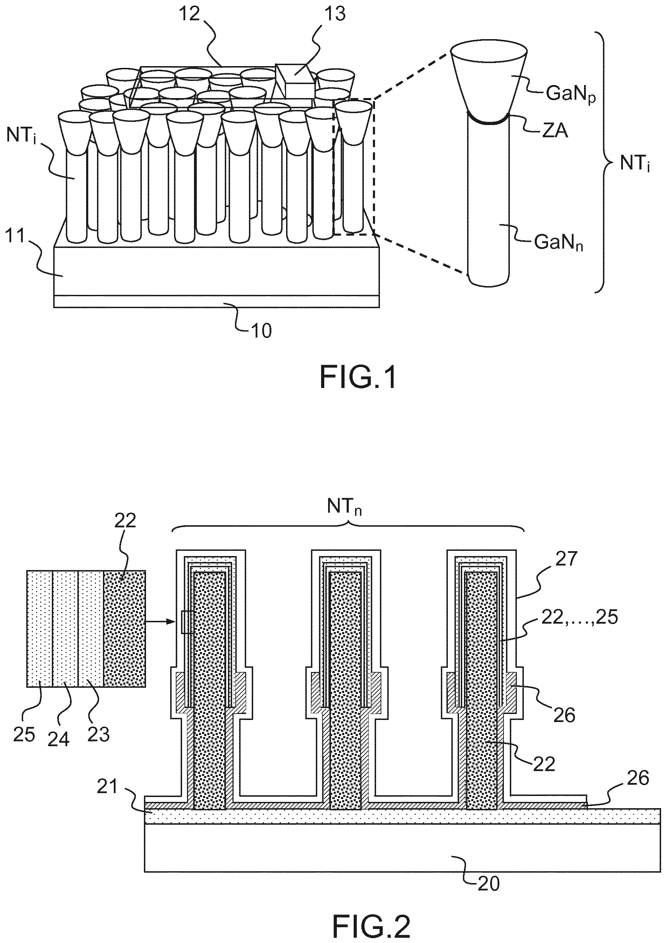

La figure 1 illustre une telle configuration mettant en évidence des nanofils NTᵢ à la surface d'un substrat 11 typiquement en silicium en contact avec un contact inférieur 10, le contact supérieur de type p étant assuré par une couche transparente 12 et la reprise de contact effectuée par une reprise épaisse 13. Les nanofils NTᵢ de structure axiale comportent une zone dopée n pouvant typiquement être en GaN dopée n, une zone active ZA en InGaN ou possédant une structure à puits quantiques, ou à multi-puits quantiques et une zone dopée p pouvant être en GaN dopée p.

Avec la technique de croissance par jets moléculaires (MBE), certaines inhomogénéités apparaissent en raison de mécanismes de nucléation aléatoire, mais typiquement il a été obtenu une puissance optique sur un fil unique émettant à 550nm de 50nW, soit 5 W/mm² avec une centaine de nanofils émetteurs/mm².

Plus récemment, la technique de croissance MOCVD (dépôt chimique en phase vapeur à base d'organométalliques) a permis la réalisation de nanofils InGaN/GaN contenant une structure LED radiale (configuration Coeur/Coquille).

La figure 2 illustre ce type de configuration dans laquelle, des nanofils NTₙ sont réalisés à la surface d'un substrat 20 recouvert d'une couche de nucléation 21 permettant de faire l'adaptation de maille entre par exemple un substrat en silicium et des nanofils en GaN.

La structure des nanofils présentant une partie photoconductrice, comportent un coeur 22 en GaN dopé n typiquement avec un taux de dopage de 10¹⁹ cm⁻³, une structure à puits quantiques avec une alternance de couches 23, 24, pouvant respectivement être en GaN non dopée et InGaN, et enfin une couche 25 GaN dopée p avec typiquement un taux de dopage de 10¹⁹ cm⁻³. Une couche diélectrique isolante 26 est prévue afin d'isoler le coeur 22 et le contact supérieur. Il peut typiquement s'agir d'un dépôt de SiO₂ ou de SiN. Les contacts supérieurs sont assurés via une couche supérieure 27 conductrice et transparente à la longueur d'onde d'émission de la structure photoconductrice.

Dans cette approche, la structure LED étant en configuration Coeur/Coquille, la surface de la zone active est plus importante que dans l'approche LEDs nanofils 2D.

Cette propriété apporte deux avantages : l'augmentation de la surface émissive et la diminution des densités de courant dans la zone active. Des structures complètes de LEDs nanofils MOCVD ont été réalisées sur substrat silicium et l'électroluminescence dans le domaine spectral bleu (450nm) a été obtenue sur un ensemble de nanofils intégrés après process technologique.

Grâce aux technologies de croissance de nanofils, la surface d'une puce peut comprendre des centaines de milliers de colonnes sur une surface pouvant typiquement être de 1 mm².

De telles structures inédites, qui tirent parti des nanotechnologies, offrent l'avantage d'augmenter la surface d'émission et donc le flux lumineux.

Néanmoins, ce type de LED étant composé d'un nombre de nanofils très important connectés en parallèle, il est à noter, que même un nombre très faible de nanofils défectueux peut devenir responsable d'une mauvaise reproductibilité en cours de procédé de fabrication et d'un mauvais fonctionnement de la LED.

En effet, une LED élémentaire de quelques millimètres carré présentant moins de 0,1% de nanofils défectueux correspond à environ une centaine de nanofils non utilisables en raison notamment de court-circuits ou de défauts structurels entraînant un disfonctionnement au niveau de la zone active, générés lors du procédé de fabrication.

De manière générale, les nanofils peuvent aussi être capables d'absorber un rayonnement à une première longueur inférieure à leur longueur d'onde d'émission, permettant ainsi de les commander optiquement pour qu'ils émettent à la longueur d'onde d'émission souhaitée.

C'est dans ce contexte, que la présente invention a pour objet un procédé optimisé de fabrication de dispositif notamment de type LED dans lequel il devient possible d'isoler les nanofils défectueux.

Plus précisément, la présente invention a pour objet un procédé de fabrication d'un ensemble de nanofils à la surface d'un substrat, lesdits nanofils présentant une partie capable d'émettre un rayonnement à au moins une longueur d'onde λ sous l'action d'une commande électrique ou optique et étant au moins partiellement connectés entre eux électriquement via une couche supérieure conductrice, caractérisé en ce qu'il comporte des étapes permettant l'identification d'un sous-ensemble de nanofils défectueux parmi des nanofils actifs, lesdites étapes comprenant :
- la réalisation d'une couche de résine photosensible négative, sensible à ladite longueur d'onde d'émission λ, recouvrant l'ensemble desdits nanofils ;
- l'activation de l'ensemble desdits nanofils sous commande électrique ou sous commande optique de manière à ce que lesdits nanofils actifs émettent ledit rayonnement en direction de ladite résine, ledit rayonnement réduisant la solubilité de ladite résine négative ;

- le développement de ladite résine au niveau des nanofils défectueux, laissant des zones rendues moins solubles et entourant lesdits nanofils actifs ;
- le retrait de ladite couche conductrice au dessus desdits nanofils défectueux.

Selon une variante de l'invention, ladite résine comprenant des interstices entre deux nanofils consécutifs, le procédé comprend la réalisation de motifs absorbants à ladite longueur d'onde λ dans lesdits interstices.

Avantageusement, la résine photosensible négative peut être autoconformée de manière à s'adapter à la forme des nanofils.

L'invention a aussi pour objet un procédé de fabrication d'un ensemble de nanofils à la surface d'un substrat, lesdits nanofils présentant une partie capable d'émettre un rayonnement à au moins une longueur d'onde λ sous l'action d'une commande électrique ou optique et étant au moins partiellement connectés entre eux électriquement via une couche supérieure conductrice, caractérisé en ce qu'il comporte des étapes d'identification d'un sous-ensemble de nanofils défectueux parmi des nanofils actifs, lesdites étapes comprenant :
- le dépôt d'une couche de résine photosensible positive absorbante et sensible à une longueur d'onde dite auxiliaire λₐ recouvrant l'ensemble desdits nanofils ;
- l'exposition de ladite résine positive à l'exception de régions situées entre deux nanofils consécutifs, à un rayonnement à ladite longueur d'onde auxiliaire λₐ ;
- le développement de ladite résine positive définissant des motifs situés dans lesdites régions entre deux nanofils consécutifs à la surface dudit substrat, de solubilité réduite ;
- le dépôt d'une couche de résine photosensible négative, sensible à ladite longueur d'onde d'émission λ, recouvrant l'ensemble desdits nanofils et des motifs situés entre deux nanofils consécutifs ;
- l'activation de l'ensemble desdits nanofils sous commande électrique ou sous commande optique de manière à ce que lesdits nanofils actifs émettent ledit rayonnement, ledit rayonnement réduisant la solubilité de ladite résine négative ;
- le développement de ladite résine photosensible négative au niveau des nanofils défectueux, laissant des zones rendues moins solubles et entourant lesdits nanofils actifs ;
- le retrait de ladite couche conductrice au dessus desdits nanofils défectueux.

Selon une variante de l'invention, les nanofils ont des structures à base d'hétérojonction de matériaux III-V, pouvant être en GaN ou en alliage à base de GaN.

Selon une variante de l'invention, le procédé comprend la réalisation de contacts au travers de ladite résine photosensible négative.

Selon une variante de l'invention, l'activation desdits nanofils génère une dose de l'ordre de 300 à 400 mJ/ cm² dans la résine photosensible négative.

Selon une variante de l'invention, l'activation desdits nanofils est réalisée avec une commande optique, on peut typiquement utiliser un laser He,Cd émettant à une longueur d'onde d'excitation de 235 nm inférieure à la longueur d'onde d'émission des nanofils, à laquelle la zone active des nanofils est sensible pour émettre un rayonnement à une autre longueur d'onde.

Selon une variante de l'invention, le retrait de la couche conductrice est effectué par une opération chimique.

Selon une variante de l'invention, le substrat est en silicium fortement dopé n, typiquement avec un taux de dopage de 10¹⁹ cm⁻³.

Avantageusement, il peut être prévu le dépôt d'une couche métallique dans les interstices entre nanofils de manière à assurer une fonction de réflexion du rayonnement émis à ladite longueur d'onde λ, par rapport au substrat silicium.

Selon une variante de l'invention, le procédé comporte la croissance épitaxiale de nanofils à hétérojonction à base de GaN ou d'alliage comprenant du GaN, de GaN ou d'alliage comprenant du GaN dopé n et de GaN ou d'alliage comprenant du GaN dopé p.

Selon une variante de l'invention, le procédé comporte des étapes de croissance épitaxiale axiale dans un plan perpendiculaire au substrat.

Selon une variante de l'invention, le procédé comporte des étapes de croissance épitaxiale radiale dans un plan parallèle au plan du substrat.

Selon une variante de l'invention, les étapes de croissance épitaxiale sont réalisées par MOCVD.

Selon une variante de l'invention, la couche conductrice est en oxyde d'indium et d'étain (ITO) ou en oxyde de zinc.

Selon une variante de l'invention, le procédé comporte une étape de dépôt d'une couche métallique sur le substrat entre les nanofils, pouvant être réfléchissante vis-à-vis de l'émission à la longueur d'onde λ.

L'invention a aussi pour objet un procédé de fabrication de diode électroluminescente caractérisé en ce qu'il comprend le procédé de fabrication d'un ensemble de nanofils à la surface d'un substrat selon l'invention.

L'invention a encore pour objet un procédé de fabrication collective d'un ensemble de diodes électroluminescentes à la surface d'un substrat, caractérisé en ce qu'il comporte :
- le procédé de fabrication d'une série d'ensemble de nanofils à la surface dudit substrat, lesdits nanofils présentant une partie photoconductrice capable d'émettre un rayonnement à au moins une longueur d'onde λ selon l'invention ;
- la découpe dudit substrat de manière à obtenir des diodes électroluminescentes unitaires comprenant chacune un ensemble de nanofils.

L'invention sera mieux comprise et d'autres avantages apparaîtront à la lecture de la description qui va suivre donnée à titre non limitatif et grâce aux figures annexées parmi lesquelles :
- la figure 1 illustre une première configuration de LED utilisant des nanofils à structure axiale selon l'art connu ;
- la figure 2 illustre une seconde configuration de LED utilisant des nanofils à structure radiale selon l'art connu ;
- la figure 3 illustre le dépôt d'une résine négative autoconformée utilisée dans une seconde étape de fabrication de nanofils à la surface d'un substrat dans le premier exemple de procédé selon l'invention ;

- les figures 4a à 4c illustrent une troisième étape dans le premier exemple de procédé selon l'invention, comportant la réalisation de motifs absorbants et la commande électrique de la structure ainsi obtenue et permettant d'identifier les nanofils défectueux ;
- la figure 5 illustre une quatrième étape relative à l'isolement des nanofils défectueux dans le premier exemple de procédé selon l'invention ;
- la figure 6 illustre une cinquième étape relative au retrait complet de la résine négative ;
- les figures 7a et 7b schématisent une vue de dessus des connexions de nanofils, à des lignes d'interconnexion selon un procédé de fabrication classique et selon un procédé de l'invention ;
- les figures 8a à 8d illustrent une première série d'étapes dans un second exemple de procédé selon l'invention, comprenant l'utilisation d'une résine photosensible positive et la réalisation de motifs de résine positive permettant d'obtenir une structure équivalente à celle illustrée en figure 4a du premier exemple de fabrication.

L'invention va être décrite plus précisément ci-après dans le cadre de la fabrication de diodes électroluminescentes utilisant des matériaux photoconducteurs à base de GaN, émettant dans le domaine spectral bleu (450nm) et de structure Coeur/Coquille et ce sur un substrat en silicium.

En effet, de manière générale, le substrat utilisé peut être en GaN, ou en saphir ou bien encore en silicium, néanmoins ce dernier présente de nombreux avantages et notamment en termes de coûts pour envisager des productions à grande échelle, en raison de la maîtrise que l'on peut en avoir en tant que substrat de technologie en micro-électronique.

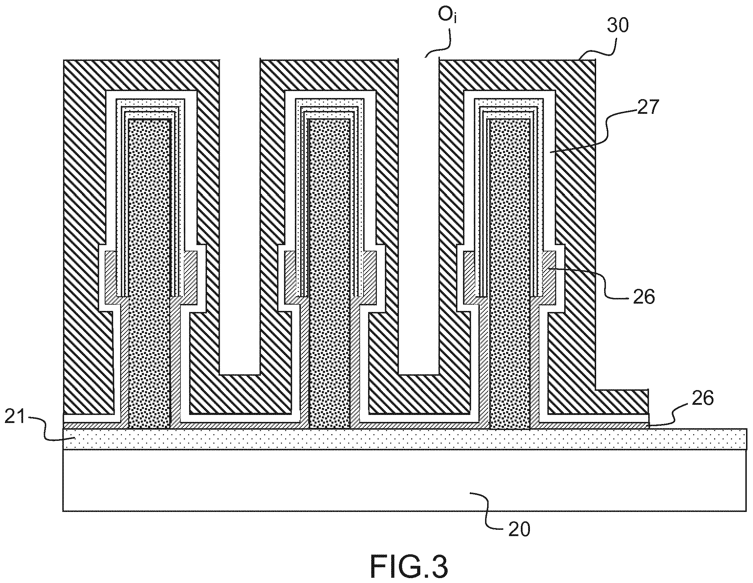

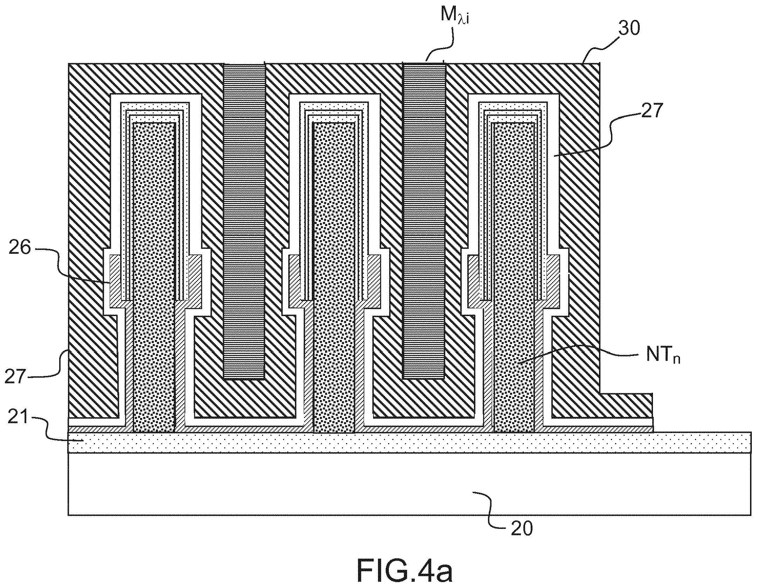

Un premier exemple de procédé de fabrication est illustré grâce notamment aux figures 3 à 5 et concernant une structure de nanofils de type coeur/coquille:
Première série d'étapes communes à l'art connu :
   On réalise un ensemble de nanofils NTₙ tels que ceux illustrés en figure 2.
Seconde série d'étapes :
   Comme illustré en figure 3, on procède alors au dépôt d'une résine négative photosensible 30 dans la gamme de longueurs d'onde d'émission des nanofils photoconducteurs. Avec ce type de résine négative, dans les zones exposées, les photons réagissent avec la résine photosensible négative et dégradent ses propriétés de solubilité, la résine exposée devenant moins soluble.
   Des motifs sélectifs pourront ensuite être révélés dans un développeur (typiquement une solution aqueuse basique), en effet les zones de la résine peu solubles dans le développeur subsistant ainsi à la surface du substrat, le reste étant solubilisé dans le développeur.
   La résine peut de plus être choisie de manière à être capable de s'autoconformer, c'est-à-dire de s'adapter au plus près de la forme des nanofils. Il peut par exemple s'agir d'une résine XP Microspray© de la société MicroChem applicable en spray. L'autoconformation de la résine permet de laisser des interstices ou ouvertures Oi entre deux nanofils adjacents.
   Durant l'étape de dépôt de la résine photosensible, les plots de contact non représentés sont protégés.
Troisième série d'étapes :
   On procède alors comme illustré en figure 4a, au dépôt d'une encre dans les interstices Oi permettant de définir des motifs absorbants M_{λi}, de matériau absorbant dans la gamme de longueurs d'onde de sensibilité des nanofils. Typiquement, il peut s'agir d'un mélange de phtalocyanine de cuivre et de disazopyrazolone dans une solution acrylique.

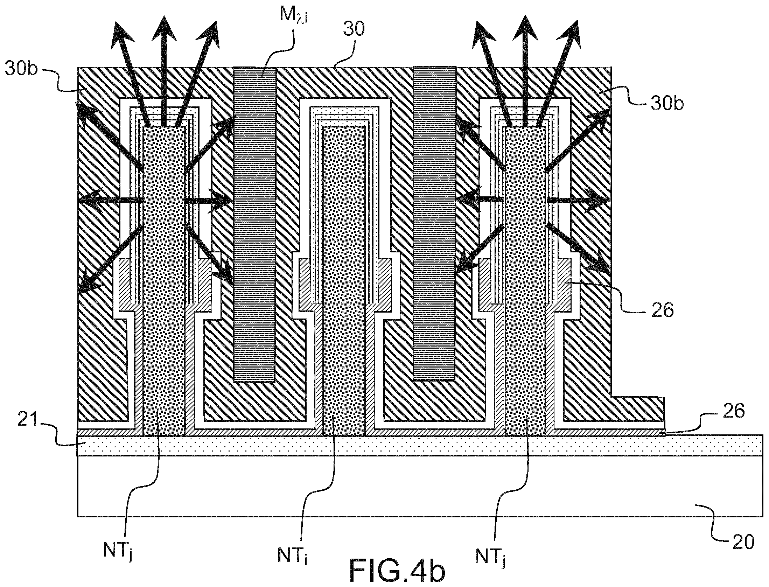

Par injection de courant depuis les plots de commande, on active les nanofils comme illustré en figure 4b. Sur cette figure, sont représentés deux nanofils actifs NTⱼ et un nanofil défectueux NTᵢ, les nanofils émettant un rayonnement représenté par les flèches en trait épais. L'intérêt de l'encre absorbante et ainsi des motifs M_{λi} dans les interstices Oᵢ, réside dans le fait d'empêcher que la résine qui enrobe un nanofil défectueux soit éclairée par un nanofil voisin.

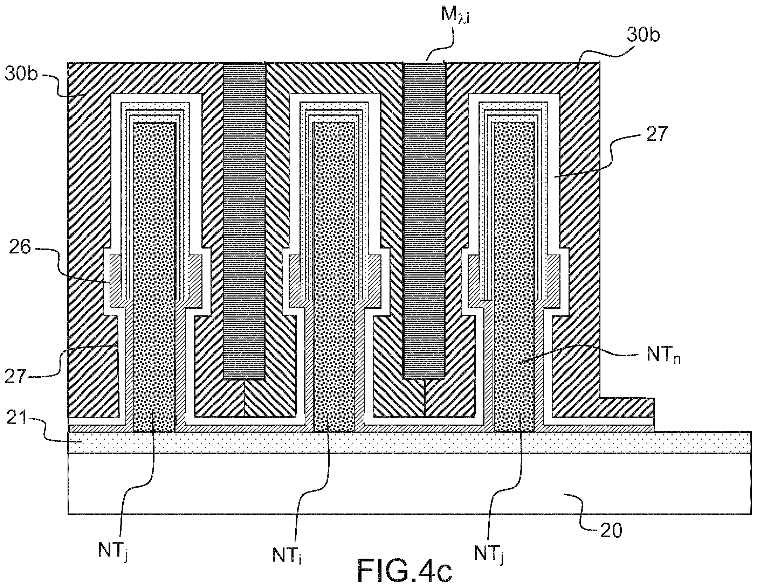

L'illumination générée crée dans les régions 30b de résine, des zones de résine peu solubles comme représentées en figure 4c, qui illustre les parties de résine insolées, différentes de la partie de résine non-insolée.

Pour réaliser cette phase de test, on peut avantageusement utiliser une carte de contrôle qui est une interface entre un système de test électronique et le substrat sur lequel a été réalisé l'ensemble de nanofils.

Typiquement, la carte de contrôle est mécaniquement accouplée à un testeur et connectée électriquement à un appareil de contrôle. Son but est de fournir un chemin électrique entre le système de test et les circuits sur le substrat comportant l'ensemble des nanofils, et permettant ainsi de procéder à l'essai et à la validation des circuits au niveau de la plaquette, le plus souvent avant que le substrat ne soit découpé en modules élémentaires.

Une alternative à la commande électrique est la commande optique. En effet, on peut également exciter l'ensemble des nanofils NTₙ, à une longueur d'onde à laquelle ils sont sensibles pour émettre un rayonnement à une longueur d'onde d'émission choisie.

On peut utiliser un laser émettant à une longueur d'onde d'excitation de 235 nm inférieure à la longueur d'onde d'émission des nanofils et à laquelle la résine 30 est transparente. Les nanofils défectueux, en raison par exemple de défauts structurels, ne seront pas en mesure d'émettre un rayonnement capable de modifier la solubilité de la résine photosensible négative et donc de permettre de conserver une enveloppe de protection autour des nanofils actifs NTᵢ.

### Quatrième série d'étapes :

On procède alors au développement et au retrait de la résine photosensible dans les régions où celle-ci n'a pas été rendue peu soluble, (et donc à l'exception des régions 30b), lesdites régions intégrant également les éléments absorbants. On peut avantageusement utiliser une solution à base de composé d'ammonium quaternaire choisi dans le groupe constitué d'hydroxyde de tétraméthylammonium (TMAH), connu pour son comportement sélectif et notamment vis-à-vis des éléments métalliques. La concentration de cette solution peut être par exemple de 0,26N.

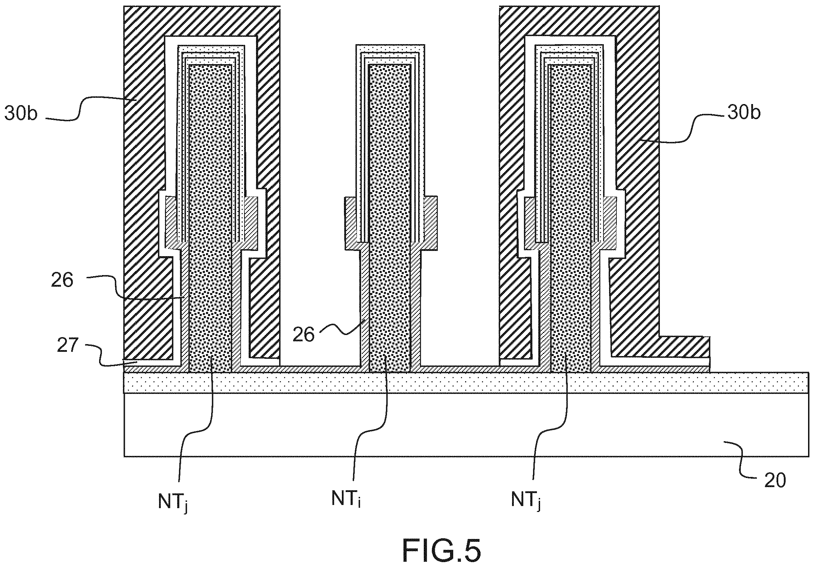

On peut alors réaliser le retrait de la couche conductrice 27 pouvant être en ITO, au niveau des nanofils défectueux en raison de court-circuits, laissés à nus. Ce retrait peut être réalisé par attaque chimique. Typiquement on peut utiliser dans le cas de l'ITO, une solution à base de HCl et de FeCl₃ dans le rapport de 2 :1,5. La figure 5 met en évidence cette élimination de la couche conductrice

### Cinquième étape :

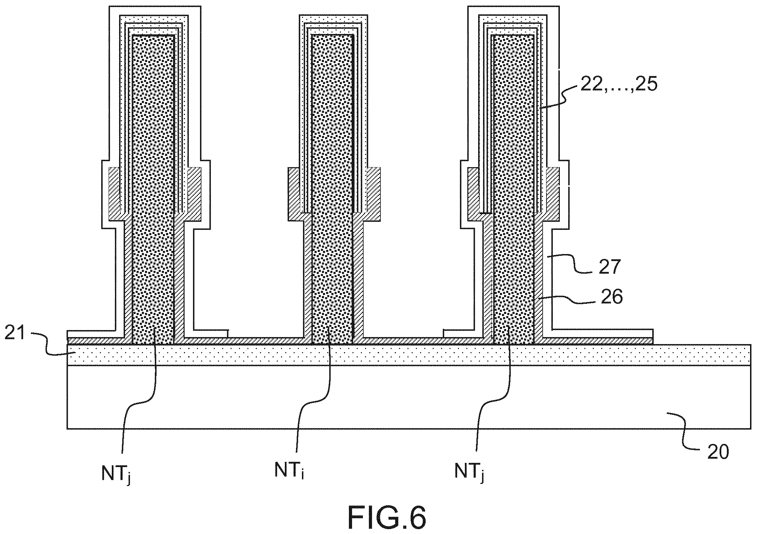

On peut procéder au retrait de la résine demeurant autour des nanofils actifs NTⱼ avec de l'acétone, comme illustré en figure 6.

L'ensemble des séries d'étapes précédentes conduisent ainsi à ne conserver que des nanofils actifs Nj recouverts de couche conductrice.

On dispose ainsi d'un substrat comprenant un ensemble de nanofils photoconducteurs permettant de réaliser des LEDs de qualité.

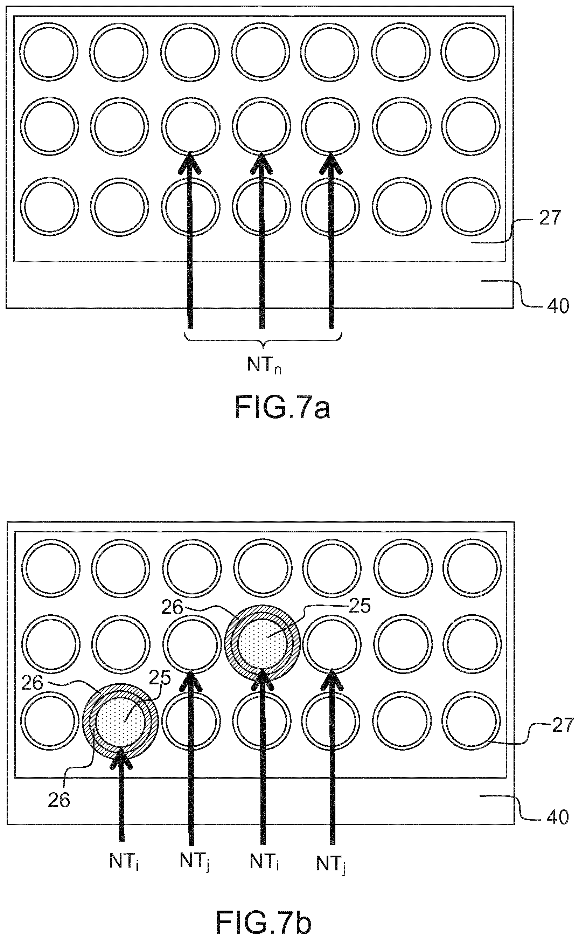

Les figures 7a et 7b mettent en évidence la couche de contact supérieur, selon l'art connu et selon l'invention qui permet d'isoler les nanofils défectueux.

La figure 7a met en évidence en périphérie un anneau 40 de reprise de contact sur le substrat, tous les nanfofils NTₙ, y compris les nanofils défectueux sont en contact avec la couche conductrice supérieure 27.

La figure 7b met en évidence la configuration obtenue avec le procédé de la présente invention, montrant que les nanofils défectueux Nᵢ ne sont plus en contact avec la couche 27, lesdits nanofils défectueux étant dégagés et laissant à nu leur partie supérieure 25 et localement la couche diélectrique 26.

### Second exemple de procédé de fabrication :

Une variante de procédé de l'invention peut comprendre l'utilisation d'une résine photosensible positive pour réaliser des motifs absorbants puis l'emploi d'une résine photosensible négative non autoconformée.

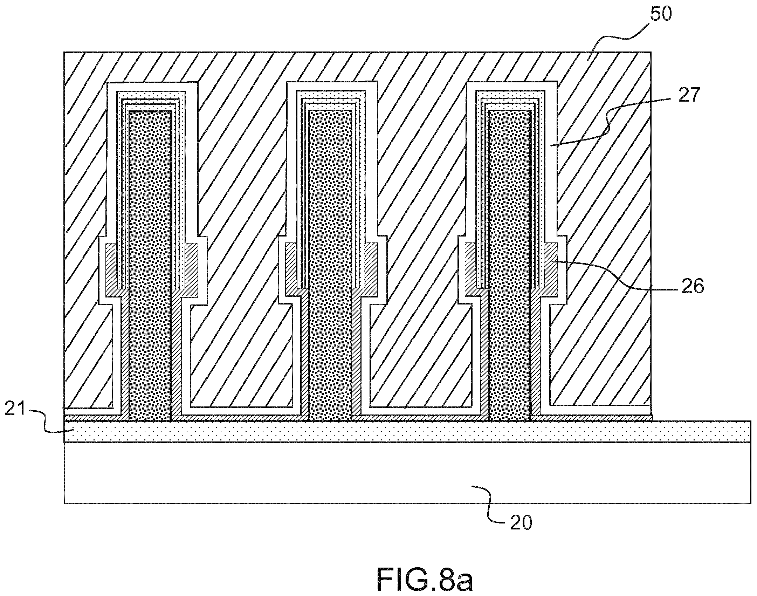

Pour ce faire comme illustré en figure 8a, après l'ensemble des étapes notamment précédemment décrites dans la première série d'étapes du premier exemple, pour réaliser les nanofils à la surface du substrat, on procède au dépôt d'une résine photosensible positive 50, sensible à une longueur d'onde auxiliaire λₐ, appartenant à un autre domaine spectral que le domaine d'émission des nanofils, typiquement cette longueur d'onde peut être située dans le domaine UV et plus précisément inférieure à 370 nm.

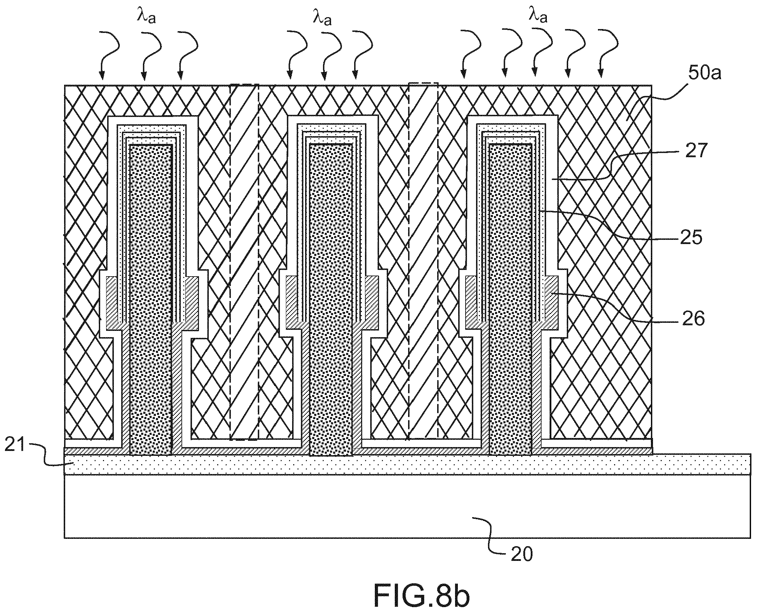

La figure 8b met en évidence l'étape d'insolation locale, permettant de former des régions 50a de solubilité accrue.

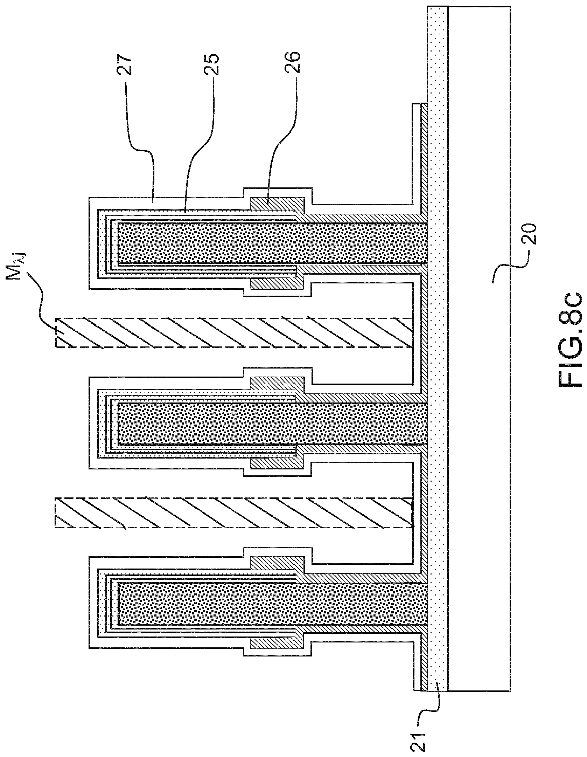

Le développement de cette résine positive laisse des motifs M_{λj} (qui n'ont pas été dissous lors du développement de ladite résine positive) à la surface du substrat entre deux nanofils consécutifs, comme illustré en figure 8c.

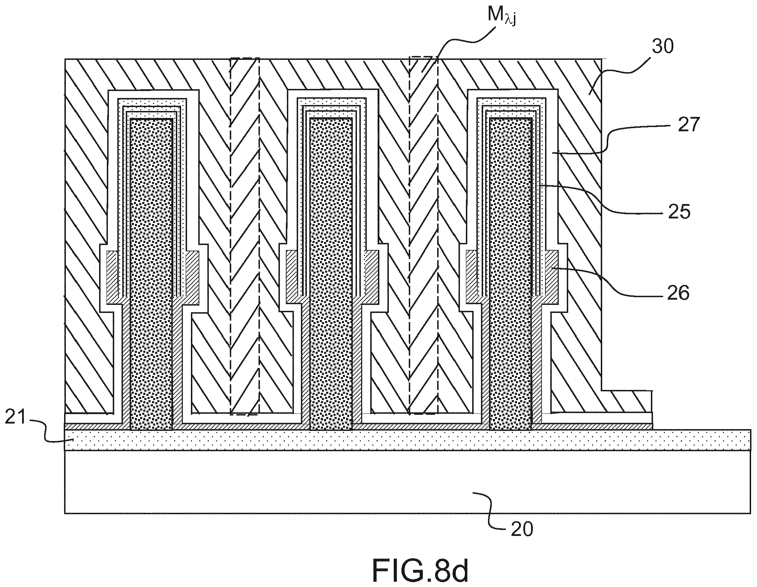

On vient déposer de la résine 30 photosensible négative et sensible à la longueur d'onde λ, cette résine n'ayant pas besoin d'être autoconformée, et ce au dessus de la résine positive, et des motifs M_{λj}, comme illustré en figure 8d.

L'ensemble des étapes ultérieures peut être équivalent à celui du premier exemple de procédé précédemment décrit.

Quel que soit le procédé de fabrication de nanofils précédemment décrits, il permet un traitement collectif sur un wafer présentant une densité en nanofils pouvant être de l'ordre de 10⁷ nanofils / cm², organisés en sous-ensembles, chaque sous-ensemble étant connecté à des plots de connexion. Une méthode de test permet de révéler de manière collective l'ensemble des nanofils défectueux, de les isoler électriquement, puis de procéder aux découpes unitaires destinées à la réalisation des LEDs individuelles.

## Revendications

1. Procédé de fabrication d'un ensemble de nanofils (NTₙ) à la surface d'un substrat, lesdits nanofils présentant une partie capable d'émettre un rayonnement à au moins une longueur d'onde (λ) sous l'action d'une commande électrique ou optique et étant au moins partiellement connectés entre eux électriquement via une couche supérieure conductrice, **caractérisé en ce qu'**il comporte des étapes permettant l'identification d'un sous-ensemble de nanofils défectueux (NTᵢ) parmi des nanofils actifs (NTⱼ), lesdites étapes comprenant :
- la réalisation d'une couche de résine photosensible négative, sensible à ladite longueur d'onde d'émission (λ), recouvrant l'ensemble desdits nanofils ;
- l'activation de l'ensemble desdits nanofils sous commande électrique ou commande optique, de manière à ce que lesdits nanofils actifs émettent ledit rayonnement, ledit rayonnement réduisant la solubilité de ladite résine négative ;
- le développement de ladite résine au niveau des nanofils défectueux (NTᵢ), laissant des zones rendues moins solubles et entourant lesdits nanofils actifs (NTⱼ) ;
- le retrait de ladite couche conductrice au dessus desdits nanofils défectueux.

2. Procédé de fabrication d'un ensemble de nanofils (NTₙ) à la surface d'un substrat selon la revendication 1, **caractérisé en ce que** ladite résine comprenant des interstices (Oi) entre deux nanofils consécutifs, il comprend la réalisation de motifs absorbants (M_{λi}) à ladite longueur d'onde λ dans lesdits interstices (Oi).

3. Procédé de fabrication d'un ensemble de nanofils (NTₙ) à la surface d'un substrat, lesdits nanofils présentant une partie capable d'émettre un rayonnement à au moins une longueur d'onde (λ) sous l'action d'une commande électrique ou optique et étant au moins partiellement connectés entre eux électriquement via une couche supérieure conductrice, **caractérisé en ce qu'**il comporte des étapes d'identification d'un sous-ensemble de nanofils défectueux (NTᵢ) parmi des nanofils actifs (NTⱼ), lesdites étapes comprenant :
- le dépôt d'une couche de résine photosensible positive absorbante à ladite longueur d'onde d'émission et sensible à une longueur d'onde dite auxiliaire (λₐ), recouvrant l'ensemble desdits nanofils ;
- l'exposition de ladite résine positive à l'exception de régions situées entre deux nanofils consécutifs, à un rayonnement à ladite longueur d'onde auxiliaire (λₐ) de manière à créer des motifs (Mλⱼ) de solubilité réduite ;
- le développement de ladite résine positive de manière à ne laisser que lesdits motifs (Mλⱼ) de résine positive entre deux nanofils consécutifs à la surface dudit substrat, de solubilité réduite ;
- le dépôt d'une couche de résine photosensible négative, sensible à ladite longueur d'onde d'émission (λ), recouvrant l'ensemble desdits nanofils et des motifs situés entre deux nanofils consécutifs ;
- l'activation de l'ensemble desdits nanofils sous commande électrique ou commande optique de manière à ce que lesdits nanofils actifs émettent ledit rayonnement, ledit rayonnement réduisant la solubilité de ladite résine négative ;
- le développement de ladite résine photosensible négative au niveau des nanofils défectueux, laissant des zones rendues moins solubles et entourant lesdits nanofils actifs ;
- le retrait de ladite couche conductrice au dessus desdits nanofils défectueux.

4. Procédé de fabrication d'un ensemble de nanofils (NTₙ) à la surface d'un substrat selon l'une des revendications 1 à 3, **caractérisé en ce que** les nanofils ont des structures à base d'hétérojonction de matériaux III-V.

5. Procédé de fabrication d'un ensemble de nanofils (NTₙ) à la surface d'un substrat selon l'une des revendications 1 à 4, **caractérisé en ce qu'**il comprend la réalisation de contacts au travers de ladite résine photosensible négative.

6. Procédé de fabrication d'un ensemble de nanofils (NTₙ) à la surface d'un substrat selon l'une des revendications 1 à 5, **caractérisé en ce que** l'activation desdits nanofils est réalisée par commande optique à une longueur d'onde pouvant être de l'ordre de 235 nm.

7. Procédé de fabrication d'un ensemble de nanofils (NTₙ) à la surface d'un substrat selon l'une des revendications 1 à 6, **caractérisé en ce que** le retrait de la couche conductrice est effectué par une opération chimique.

8. Procédé de fabrication d'un ensemble de nanofils (NTₙ) à la surface d'un substrat selon l'une des revendications 1 à 7, **caractérisé en ce que** les nanofils sont à base de GaN ou d'alliage comprenant du GaN.

9. Procédé de fabrication d'un ensemble de nanofils (NTₙ) à la surface d'un substrat selon la revendication 8, **caractérisé en ce qu'**il comporte la croissance épitaxiale de nanofils à hétérojonction à base de GaN ou d'alliage comprenant du GaN, de GaN ou d'alliage comprenant du GaN dopé n et de GaN ou d'alliage comprenant du GaN dopé p.

10. Procédé de fabrication d'un ensemble de nanofils (NTₙ) à la surface d'un substrat selon la revendication 9, **caractérisé en ce qu'**il comporte des étapes de croissance épitaxiale axiale dans un plan perpendiculaire au substrat.

11. Procédé de fabrication d'un ensemble de nanofils (NTₙ) à la surface d'un substrat selon la revendication 9, **caractérisé en ce qu'**il comporte des étapes de croissance épitaxiale radiale dans un plan parallèle au plan du substrat.

12. Procédé de fabrication collective d'un ensemble de diodes électroluminescentes à la surface d'un substrat, **caractérisé en ce qu'**il comporte :
- le procédé de fabrication d'une série d'ensemble de nanofils (NTₙ) à la surface dudit substrat, lesdits nanofils présentant une partie photoconductrice capable d'émettre un rayonnement à au moins une longueur d'onde (λ) selon l'une des revendications 1 à 11 ;
- la découpe dudit substrat de manière à obtenir des diodes électroluminescentes unitaires comprenant chacune un ensemble de nanofils (NTₙ).

## Patentansprüche

1. Verfahren zur Herstellung eines Satzes von Nanodrähten (NTₙ) an der Oberfläche eines Substrats, wobei die Nanodrähte einen Teil aufweisen, der Strahlung mit wenigstens einer Wellenlänge (λ) unter der Wirkung einer elektrischen oder optischen Steuerung aussenden kann, und wenigstens teilweise über eine leitende obere Schicht elektrisch miteinander verbunden sind, **dadurch gekennzeichnet, dass** es Schritte beinhaltet, die die Identifikation eines Teilsatzes von defekten Nanodrähten (NTᵢ) unter den aktiven Nanodrähten (NTⱼ) beinhalten, wobei die Schritte Folgendes beinhalten:
- Erzeugen einer Schicht von fotosensiblem negativem Harz, der für die Emissionswellenlänge (λ) empfindlich ist und den Satz der Nanodrähte bedeckt;
- Aktivieren des Satzes der Nanodrähte unter elektrischer Steuerung oder optischer Steuerung, so dass die aktiven Nanodrähte die Strahlung aussenden, wobei die Strahlung die Löslichkeit des negativen Harzes reduziert;
- Entwickeln des Harzes an den defekten Nanodrähten (NTᵢ), wobei Zonen weniger löslich gemacht werden, so dass sie die aktiven Nanodrähte (NTⱼ) umgeben;
- Abziehen der leitenden Schicht über den defekten Nanodrähten.

2. Verfahren zur Herstellung eines Satzes von Nanodrähten (NTₙ) an der Oberfläche eines Substrats nach Anspruch 1, **dadurch gekennzeichnet, dass** das Verfahren, da das Harz Zwischenräume (Oi) zwischen zwei konsekutiven Nanodrähten beinhaltet, das Realisieren von absorptionsfähigen Mustern (Mλⱼ) bei der Wellenlänge λ in den Zwischenräumen (Oi) beinhaltet.

3. Verfahren zur Herstellung eines Satzes von Nanodrähten (NTₙ) an der Oberfläche eines Substrats, wobei die Nanodrähte einen Teil aufweisen, der eine Strahlung mit wenigstens einer Wellenlänge (λ) unter der Wirkung einer elektrischen oder optischen Steuerung aussenden kann und wenigstens teilweise über eine obere leitende Schicht elektrisch miteinander verbunden sind, **dadurch gekennzeichnet, dass** es Schritte zum Identifizieren eines Teilsatzes von defekten Nanodrähten (NTᵢ) unter den aktiven Nanodrähten (NTⱼ) beinhaltet, wobei die Schritte Folgendes beinhalten:
- Absetzen einer Schicht von fotosensiblem positivem Harz, die bei der Emissionswellenlänge absorptionsfähig ist und für eine sogenannte zusätzliche Wellenlänge (λₐ) empfindlich ist, die den Satz der Nanodrähte bedeckt;
- Exponieren des positiven Harzes mit Ausnahme von Regionen, die sich zwischen zwei aufeinander folgenden Nanodrähten befinden, gegenüber Strahlung mit der zusätzlichen Wellenlänge (λₐ), um Muster (M_{λi}) mit reduzierter Löslichkeit zu erzeugen;
- Entwickeln des positiven Harzes, so dass nur die Muster (M_{λj}) mit reduzierter Löslichkeit aus positivem Harz zwischen zwei aufeinander folgenden Nanodrähten auf der Oberfläche des Substrats zurückbleiben;
- Absetzen einer fotosensiblen negativen Harzschicht, die für die Emissionswellenlänge (λ) empfindlich ist, die den Satz von Nanodrähten und die Muster bedeckt, die sich zwischen zwei aufeinander folgenden Nanodrähten befinden;
- Aktivieren des Satzes der Nanodrähte unter elektrischer Steuerung oder optischer Steuerung, so dass die aktiven Nanodrähte die Strahlung aussenden, wobei die Strahlung die Löslichkeit des negativen Harzes reduziert;
- Entwickeln des fotosensiblen negativen Harzes an den defekten Nanodrähten, wobei weniger löslich gemachte Zonen frei gelassen werden, die die aktiven Nanodrähte umgeben;
- Abziehen der leitenden Schicht über den defekten Nanodrähten.

4. Verfahren zur Herstellung eines Satzes von Nanodrähten (NTₙ) an der Oberfläche eines Substrats nach einem der Ansprüche 1 bis 3, **dadurch gekennzeichnet, dass** die Nanodrähte Strukturen mit einer Heteroübergangsbasis aus Materialien III-V haben.

5. Verfahren zur Herstellung eines Satzes von Nanodrähten (NTₙ) an der Oberfläche eines Substrats nach einem der Ansprüche 1 bis 4, **dadurch gekennzeichnet, dass** es das Realisieren von Kontakten durch das fotosensible negative Harz beinhaltet.

6. Verfahren zur Herstellung eines Satzes von Nanodrähten (NTₙ) an der Oberfläche eines Substrats nach einem der Ansprüche 1 bis 5, **dadurch gekennzeichnet, dass** die Aktivierung der Nanodrähte durch optische Steuerung bei einer Wellenlänge realisiert wird, die in der Größenordnung von 235 nm liegen kann.

7. Verfahren zur Herstellung eines Satzes von Nanodrähten (NTₙ) an der Oberfläche eines Substrats nach einem der Ansprüche 1 bis 6, **dadurch gekennzeichnet, dass** das Abziehen der leitenden Schicht durch einen chemischen Vorgang erfolgt.

8. Verfahren zur Herstellung eines Satzes von Nanodrähten (NTₙ) an der Oberfläche eines Substrats nach einem der Ansprüche 1 bis 7, **dadurch gekennzeichnet, dass** die Nanodrähte auf GaN oder einer GaN umfassenden Legierung basieren.

9. Verfahren zur Herstellung eines Satzes von Nanodrähten (NTₙ) an der Oberfläche eines Substrats nach Anspruch 8, **dadurch gekennzeichnet, dass** es das epitaxiale Wachstum von Nanodrähten mit einem Heteroübergang auf der Basis von GaN oder einer GaN enthaltenden Legierung, von GaN oder Legierung, die mit n dotiertes GaN umfasst, oder von GaN oder Legierung, die mit p dotiertes GaN umfasst, beinhaltet.

10. Verfahren zur Herstellung eines Satzes von Nanodrähten (NTₙ) an der Oberfläche eines Substrats nach Anspruch 9, **dadurch gekennzeichnet, dass** es die Schritte des axialen epitaxialen Wachstums in einer Ebene lotrecht zu dem Substrat beinhaltet.

11. Verfahren zur Herstellung eines Satzes von Nanodrähten (NTₙ) an der Oberfläche eines Substrats nach Anspruch 9, **dadurch gekennzeichnet, dass** es die Schritte des radialen epitaxialen Wachstums in einer Ebene parallel zur Ebene des Substrats beinhaltet.

12. Verfahren zur kollektiven Herstellung eines Satzes von elektrolumineszenten Dioden an der Oberfläche eines Substrats, **dadurch gekennzeichnet, dass** es die folgenden Schritte beinhaltet:
- das Verfahren zur Herstellung einer Serie von Sätzen von Nanodrähten (NTₙ) an der Oberfläche des Substrats, wobei die Nanodrähte einen fotoleitenden Teil aufweisen, der eine Strahlung mit wenigstens einer Wellenlänge (λ) nach einem der Ansprüche 1 bis 11 beinhaltet;
- Abschneiden des Substrats, um einzelne elektrolumineszente Dioden zu erhalten, die jeweils einen Satz von Nanodrähten (NTₙ) umfassen.

## Claims

1. A process for fabricating a set of nanowires (NTₙ) on the surface of a substrate, said nanowires comprising a portion capable of emitting radiation at at least one wavelength (λ) under the action of an electrical or optical control and being at least partially connected to one another electrically via a conductive upper layer, **characterised in that** it comprises steps allowing the identification of a subset of defective nanowires (NTᵢ) among active nanowires (NTⱼ), said steps comprising:
- producing a layer of negative photosensitive resin that is sensitive to said emission wavelength (λ), covering the set of said nanowires;
- activating the set of said nanowires under electrical control or optical control, so that said active nanowires emit said radiation, said radiation decreasing the solubility of said negative resin;
- developing said resin at the defective nanowires (NTᵢ), leaving zones made less soluble and encircling said active nanowires (NTⱼ);
- removing said conductive layer above said defective nanowires.

2. The process for fabricating a set of nanowires (NTₙ) on the surface of a substrate as claimed in claim 1, **characterised in that** said resin contains interstices (Oi) between two consecutive nanowires, it comprises the production of features (Mλⱼ) that are absorbent at said wavelength λ in said interstices (Oi).

3. A process for fabricating a set of nanowires (NTₙ) on the surface of a substrate, said nanowires comprising a portion capable of emitting radiation at at least one wavelength (λ) under the action of an electrical or optical control and being at least partially connected to one another electrically via an upper conductive layer, **characterised in that** it comprises steps of identifying a subset of defective nanowires (NTᵢ) among active nanowires (NTⱼ), said steps comprising:
- depositing a layer of positive photosensitive resin that is absorbent at said emission wavelength and sensitive to what is referred to as an auxiliary wavelength (λₐ), covering the set of said nanowires;
- exposing said positive resin, except in regions located between two consecutive nanowires, to radiation at said auxiliary wavelength (λₐ) so as to create features (Mλⱼ) of decreased solubility;
- developing said positive resin so as to leave only said positive resin features (Mλⱼ) of decreased solubility between two consecutive nanowires on the surface of said substrate;
- depositing a layer of negative photosensitive resin that is sensitive to said emission wavelength (λ), covering the set of said nanowires and of the features located between two consecutive nanowires;
- activating the set of said nanowires under electrical control or optical control so that said active nanowires emit said radiation, said radiation decreasing the solubility of said negative resin;
- developing said negative photosensitive resin at the defective nanowires, leaving zones made less soluble and encircling said active nanowires;
- removing said conductive layer above said defective nanowires.

4. The process for fabricating a set of nanowires (NTₙ) on the surface of a substrate as claimed in any one of claims 1 to 3, **characterised in that** the nanowires have structures based on a heterojunction of III-V materials.

5. The process for fabricating a set of nanowires (NTₙ) on the surface of a substrate as claimed in any one of claims 1 to 4, **characterised in that** it comprises producing contacts through said negative photosensitive resin.

6. The process for fabricating a set of nanowires (NTₙ) on the surface of a substrate as claimed in any one of claims 1 to 5, **characterised in that** said nanowires are activated by optical control at a wavelength possibly of the order of 235 nm.

7. The process for fabricating a set of nanowires (NTₙ) on the surface of a substrate as claimed in claims 1 to 6, **characterised in that** the conductive layer is removed by a chemical operation.

8. The process for fabricating a set of nanowires (NTₙ) on the surface of a substrate as claimed in any one of claims 1 to 7, **characterised in that** the nanowires are based on GaN or an alloy containing GaN.

9. The process for fabricating a set of nanowires (NTₙ) on the surface of a substrate as claimed in claim 8, **characterised in that** it comprises epitaxial growth of heterojunction nanowires based on GaN or an alloy containing GaN, GaN or an alloy containing n-doped GaN and GaN or an alloy containing p-doped GaN.

10. The process for fabricating a set of nanowires (NTₙ) on the surface of a substrate as claimed in claim 9, **characterised in that** it comprises steps of axial epitaxial growth in a plane perpendicular to the substrate.

11. The process for fabricating a set of nanowires (NTₙ) on the surface of a substrate as claimed in claim 9, **characterised in that** it comprises steps of radial epitaxial growth in a plane parallel to the plane of the substrate.

12. A process for collective fabrication of a set of light-emitting diodes on the surface of a substrate, **characterised in that** it comprises:
- the process for fabricating a series of sets of nanowires (NTₙ) on the surface of said substrate, said nanowires comprising a photoconductive portion capable of emitting radiation at at least one wavelength (λ) as claimed in any one of claims 1 to 11;
- cutting said substrate so as to obtain unitary light-emitting diodes each comprising one set of nanowires (NTₙ).
